# EUROPEAN PATENT APPLICATION

(11) **EP 1 037 382 A2**
(43) Date of publication of application: **20.09.2000**
(21) Application number: 00400666.4
(22) Date of filing: 10.03.2000
(51) Int. Cl.: H03H 9/02

(54) **Surface acoustic wave resonator, surface acoustic wave filter, duplexer, communication apparatus, and surface acoustic wave device**

(30) Priority: 11.03.1999 JP 6490799
(71) Applicant: Murata Manufacturing Co., Ltd., Nagaokakyo-shi Kyoto-fu 617-8555 (JP)
(72) Inventor: Kadota, Michio, c/o (A170) Intellectual Prop. Dep., Nagaokakyo-shi, Kyoto-fu 617-8555 (JP); Nakanishi, Jun, c/o (A170) Intellectual Prop. Dep., Nagaokakyo-shi, Kyoto-fu 617-8555 (JP); Kumatoriya, Makoto, (A170) Intellectual Prop. Dep., Nagaokakyo-shi, Kyoto-fu 617-8555 (JP)
(74) Representative: Orian, Yvette Suzanne

(57) **Abstract**

A surface acoustic wave resonator includes a piezoelectric substrate made of a langasite single crystal, and an interdigital transducer primarily made of Al and disposed on the piezoelectric substrate. The Euler angles (φ, θ, and ϕ) defining the orientation of the piezoelectric substrate are approximately 11° to 13°, 152° to 155°, and 37° ± 2°, respectively, or angles equivalent thereto, and the film thickness H of the interdigital transducer with respect to a wavelength λ of a surface acoustic wave excited on the piezoelectric substrate is in the region between about 0.005 to about 0.15.

## Description

### BACKGROUND OF THE INVENTION

### 1. Field of the Invention

The present invention relates to surface acoustic wave resonators, and surface acoustic wave filters, duplexers, and communication apparatuses, which include the surface acoustic wave resonator, and more specifically, relates to a surface acoustic wave resonator using a langasite (La₃Ga₅SiO₁₄) single crystal as a piezoelectric substrate.

### 2. Description of the Related Art

Surface acoustic wave resonators are widely used in band-pass filters and other such components included in mobile communication apparatuses. Such surface acoustic wave resonators and surface acoustic wave filters include interdigital transducers (IDT) having comb electrodes disposed on a piezoelectric substrate.

The piezoelectric substrates included in the surface acoustic wave resonators and the surface acoustic wave filters described above, may be made of piezoelectric single crystals, such as lithium niobate (LiNbO₃), lithium tantalate (LiTaO₃), quartz, and lithium tetraborate (Li₂B₄O₇).

For these surface acoustic wave resonators and the surface acoustic wave filters, an electromechanical coupling coefficient (K²), which primarily represents conversion efficiency between electric energy and mechanical energy, must be as large as possible, and a temperature characteristic of group delay time (TCD), which represents shifting rates of frequency influenced by temperature, must be low.

A surface acoustic wave filter having a substrate made of LiNbO₃ or LiTaO₃, has a great K², so that it has an advantage of a large difference between resonant frequency and antiresonant frequency, and has a relatively wider bandwidth. However, in contrast, such a surface acoustic wave filter has a disadvantage of large shifts in frequency influenced by temperature since the surface acoustic wave filter has a greater TCD compared to that of quartz.

In contrast, a surface acoustic wave filter having a substrate made of quartz mentioned above has an advantage of almost no shift in frequency caused by temperature, due to a very low TCD thereof. However, since such a surface acoustic wave filter has a low K², it has a disadvantage of a small difference between resonant frequency and antiresonant frequency, and has a relatively narrower bandwidth.

Consequently, Li₂B₄O₇ is used for surface acoustic wave filters and surface acoustic wave resonators as a material having a smaller TCD than that of LiNbO₃ and LiTaO₃, and having a greater K² than that of quartz. However, Li₂B₄O₇ has disadvantages in that it is difficult to handle due to the deliquescence thereof, and has inferior productivity due to a low growth rate of single crystals thereof. In addition, Li₂B₄O₇ has good temperature frequency characteristics. However, it has inferior temperature characteristics of K², and as a result, there is a problem in that bandwidth varies depending on temperatures.

Recently, La₃Ga₅SiO₁₄ has been studied as a material which solves the problems described above. The reasons for this are that La₃Ga₅SiO₁₄ is easy to handle due to having no deliquescence, and has a higher growth rate of the single crystals compared to that of Li₂B₄O₇. In addition, La₃Ga₅SiO₁₄ has a smaller TCD compared to that of LiNbO₃ or LiTaO₃, and has a greater K² compared to that of quartz. A number of theoretical analyses and experimental results on promising Euler angles and propagating directions of La₃Ga₅SiO₁₄ single crystal substrates, have been reported.

However, actual measured results and other related data thus reported are results observed using only La₃Ga₅SiO₁₄ single crystal substrates. Consequently, TCD can be optimized only when a La₃Ga₅SiO₁₄ single crystal substrate is used by itself, and cannot be optimized when other elements are added.

### SUMMARY OF THE INVENTION

To solve the problems described above, preferred embodiments of the present invention improve the TCD of surface acoustic wave resonators using La₃Ga₅SiO₁₄ single crystal substrates.

A surface acoustic wave resonator according to a preferred embodiment of the present invention includes a piezoelectric substrate made of a langasite single crystal, and an interdigital transducer including Al and disposed on the piezoelectric substrate, in which Euler angles (φ, θ, and ϕ) of the piezoelectric substrate are about 11° to about 13°, about 152° to about 155°, and about 37° ± 2°, respectively, and the film thickness H of the interdigital transducer with respect to a wavelength λ of a surface acoustic wave excited on the piezoelectric substrate is in the region between about 0.005 to about 0.15.

When Euler angles (12°, 0, and 37°) of the piezoelectric substrate are plotted on the abscissa and a ratio H/λ of the film thickness H of the interdigital transducer with respect to a wavelength λ excited on the piezoelectric substrate is plotted on the ordinate, 0 and H/λ of the surface acoustic wave device are preferably included in a region surrounded by the points listed below or on the lines surrounding the region:
A (θ = 152°, H/λ = 0.005),
B (θ = 153.5°, H/λ = 0.005),
C (θ = 155°, H/λ = 0.15),
D (θ = 153.5°, H/λ = 0.15).

The surface acoustic wave resonator according to various preferred embodiments of the present invention may be implemented in a surface acoustic wave filter, duplexer or communication apparatus.

According to the preferred embodiments of the present invention, a surface acoustic wave resonator having a superior TCD is achieved.

For the purpose of illustrating the invention, there is shown in the drawings several forms which are presently preferred, it being understood, however, that the invention is not limited to the precise arrangements and instrumentalities shown.

### BRIEF DESCRIPTION OF THE DRAWINGS

Fig. 1 is a perspective view of a surface acoustic wave resonator illustrating a first preferred embodiment of the present invention.

Fig. 2 is a perspective view of a longitudinally coupled surface acoustic wave filter illustrating a second preferred embodiment of the present invention.

Fig. 3 is a perspective view of a transversally coupled surface acoustic wave filter illustrating a third preferred embodiment of the present invention.

Fig. 4 is a block diagram of a communication apparatus illustrating a fourth preferred embodiment of the present invention.

Fig. 5 is a characteristic graph showing the relationship of frequency shift and temperature relating to Euler angles.

Fig. 6 is a characteristic graph showing the relationship of Euler angles and turnover temperature of frequency.

Fig. 7 is a characteristic graph showing the relationship of frequency shift and temperature, relating to film thickness of an electrode.

Fig. 8 is a characteristic graph showing the relationship of Euler angles and film thickness of an electrode for explaining preferred embodiments of the present invention.

### DETAILED DESCRIPTION OF PREFERRED EMBODIMENTS

Hereinafter, preferred embodiments of the present invention are explained in detail with reference to the drawings.

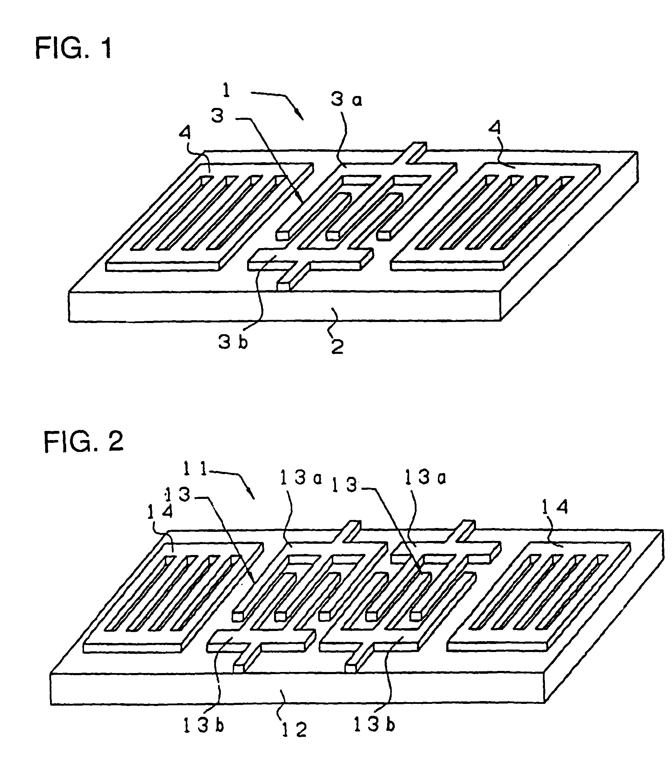

Fig. 1 is a perspective view showing a surface acoustic wave resonator of a first preferred embodiment of the present invention.

As shown in Fig. 1, the surface acoustic wave resonator 1 preferably includes an IDT 3 provided on a piezoelectric substrate 2 including and made of La₃Ga₅SiO₁₄ single crystal, and reflectors 4 provided on two ends of the IDT.

The interdigital transducer 3 is preferably made of an electrode material, such as Al or Au, and includes a pair of comb electrodes 3a and 3b which have individual teeth or fingers which are interdigitated with each other.

Next, a second preferred embodiment of the present invention will be described. Fig. 2 is a perspective view showing a longitudinally coupled surface acoustic wave filter of the second preferred embodiment of the present invention.

As shown in Fig. 2, the longitudinally coupled surface acoustic wave filter 11 includes at least two IDTs 13 disposed on a piezoelectric substrate 12 which is preferably made of a La₃Ga₅SiO₁₄ single crystal, and reflectors 14 at the respective ends of the IDTs.

The IDTs 13 are preferably made of an electrode material, such as Al or Au, and includes teeth or fingers of a pair of comb electrodes 13a and 13b being arranged to interdigitated with each other. In addition, the IDTs are aligned to be substantially parallel to a surface acoustic wave propagating direction and at a constant distance from each other.

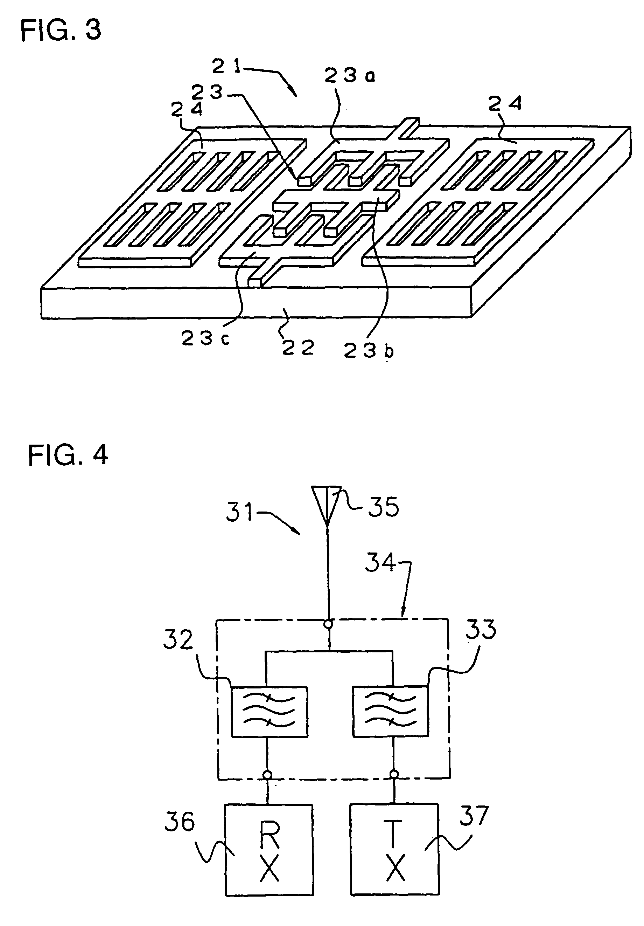

A third preferred embodiment of the present invention will be further described. Fig. 3 is a perspective view showing a transversally coupled surface acoustic wave filter of the third preferred embodiment of the present invention.

As shown in Fig. 3, the transversally coupled surface acoustic wave filter 21 preferably includes an IDT 23 provided on a piezoelectric substrate 22 which is preferably made of a La₃Ga₅SiO₁₄ single crystal. Reflectors 24 are disposed at the respective ends of the IDT 23.

The IDT 23 is preferably made of an electrode material, such as Al or Au, and includes teeth or fingers of the comb electrodes 23a and 23b which are arranged so as to interdigitate with each other.

A fourth and a fifth preferred embodiment of the present invention will be described. Fig. 4 is a block diagram showing a duplexer of the fourth preferred embodiment and a communication apparatus of the fifth preferred embodiment of the present invention.

As shown in Fig. 4, the communication apparatus 31 includes an antenna 35 connected to an antenna terminal of the duplexer 34 which is provided with a surface acoustic wave filter 32 for receiving. The communication apparatus 31 also includes a surface acoustic wave filter 33 for transmitting, an output terminal connected to a receiving circuit 36, and an input terminal connected to a transmitting circuit 37. For the surface acoustic wave filter 32 for receiving and the surface acoustic wave filter 33 for transmitting of the duplexer 34, the surface acoustic wave filters 11 and 21 described in the second and the third preferred embodiments, respectively, are preferably used.

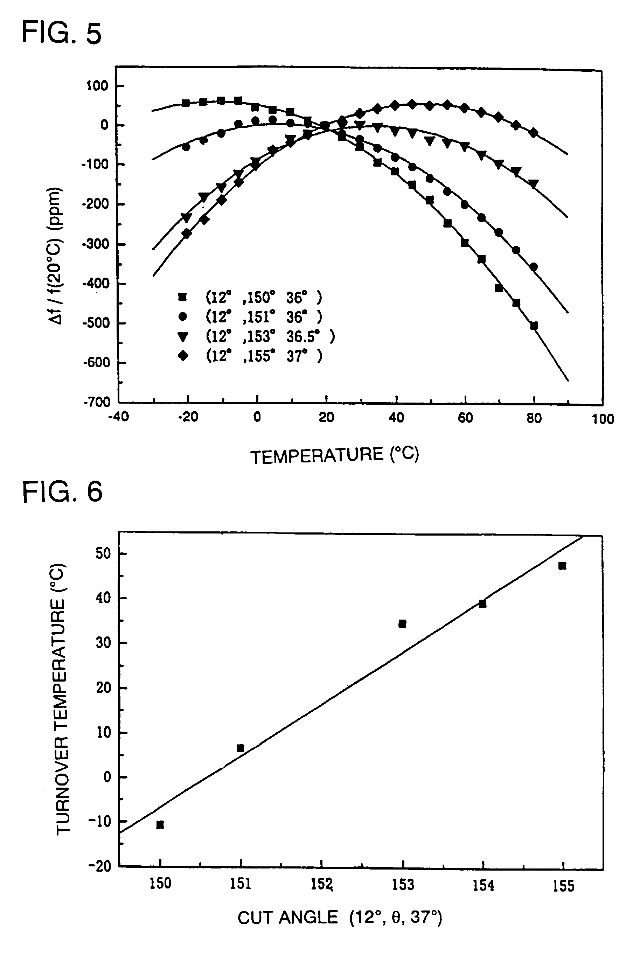

Experiments were performed relating to the changes in temperatures and frequency shifts by Euler angles of La₃Ga₅SiO₁₄ used for a substrate of the surface acoustic wave device thus described. In Fig. 5, the actual measured data of the frequency shifts influenced by temperature are represented by a substantially solid square to a substantially solid rhombus, and approximate values thereof are represented by curved lines.

As can be seen in Fig. 5, in a La₃Ga₅SiO₁₄ single crystal, it was understood that the frequency shift versus temperature drew curves having turnover temperatures of frequency at which frequency shifts were approximately zero. In addition, it was understood that these curves were shifted to higher temperature sides concomitant with increases of θ of Euler angles (φ, θ, and ϕ) of the La₃Ga₅SiO₁₄ single crystal.

Next, a turnover temperature of frequency at which frequency shift was approximately zero was measured when θ of Euler angles (φ, θ, and (ϕ ) was changed. Fig. 6, in which the turnover temperature of frequency was represented by solid square and the approximate values thereof were represented by the line, shows changes of the turnover temperatures of frequency by changing θ (Cut angle θ at Euler angle (12°, θ, and 37°) of Euler angles (φ, θ, and ϕ)).

As can be seen in Fig. 6, it was understood that the turnover temperature of frequency was shifted to a higher temperature side in accordance with an increase of θ of Euler angles (φ, θ, and ϕ) of a La₃Ga₅SiO₁₄ single crystal, in a manner similar to that the curves shown in Fig. 5 were shifted to a high temperature side in accordance with θ.

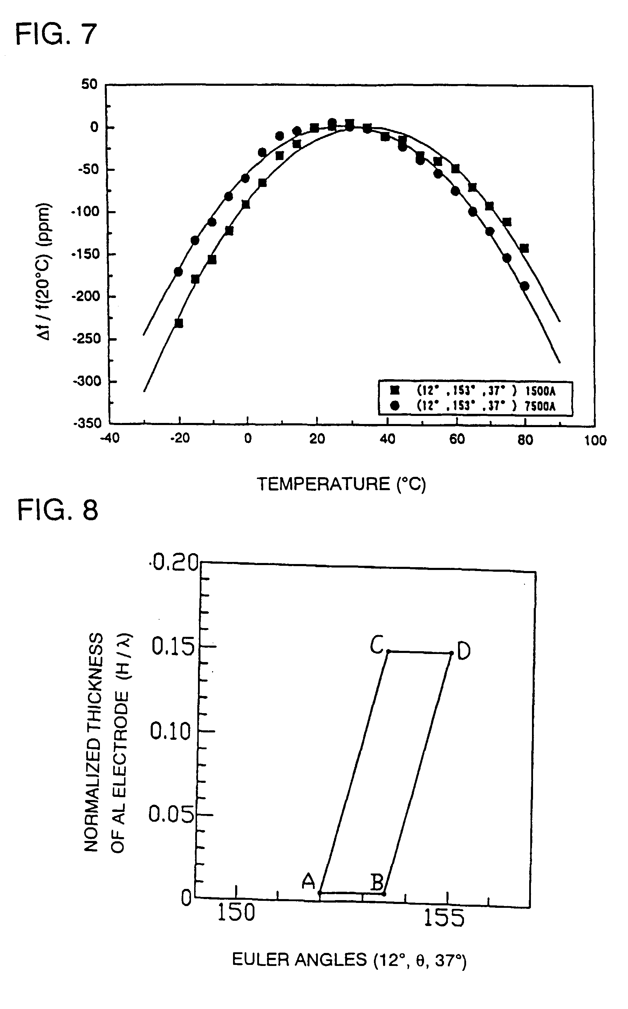

Next, the changes of the curves of the frequency shift versus temperatures in accordance with changes of a film thickness H of an aluminum electrode provided on the piezoelectric substrate of a La₃Ga₅SiO₁₄ single crystal are shown in Fig. 7.

In Fig. 7, a solid square represents actual measured data when a 1,500 Å-thick Al electrode was formed on a piezoelectric substrate made of a La₃Ga₅SiO₁₄ single crystal having Euler angles (φ, θ, and ϕ) of approximately 12°, 153°, and 37°, respectively, and a solid circle represents actual measured data when a 7,500 Å-thick Al electrode was formed on a piezoelectric substrate made of a La₃Ga₅SiO₁₄ single crystal having Euler angles (φ, θ, and ϕ) of approximately 12°, 153°, and 37°, respectively. As can be seen in Fig. 7, it was understood that the curve was shifted to a lower temperature side concomitant with an increase of the film thickness H of the aluminum electrode.

As described above, it was confirmed that the turnover temperature at which frequency shift was approximately zero was shifted to a higher temperature side concomitant with an increase of θ of Euler angles (φ, θ, and (ϕ) of a La₃Ga₅SiO₁₄ single crystal, and the turnover temperature was shifted to a lower temperature side concomitant with an increase of the thickness H of an aluminum electrode.

Since surface acoustic wave devices, such as surface acoustic wave resonators and surface acoustic wave filters, are used at room temperature, frequency shift of surface acoustic wave devices are minimized when turnover temperature of frequency at which frequency shift is approximately zero is set between about 20°C and about 30°C.

Consequently, the turnover temperature of frequency is preferably between about 20°C and about 30°C when the film thickness H of an aluminum electrode is determined in accordance with a shift of the turnover temperature of frequency to a higher temperature side by θ values of Euler angles (φ, θ, and ϕ) of a La₃Ga₅SiO₁₄ single crystal.

In the most superior range of Euler angles (φ, θ, and ϕ) of approximately 12°, 152° to 155°, and 37°, respectively, in the characteristics of a La₃Ga₅SiO₁₄ single crystal, the film thickness H of an aluminum electrode was calculated by the experiments so that the turnover temperature of frequency was between about 20°C and about 30°C.

As a result, it was understood that the turnover temperature of frequency was about 20°C at H/λ = 0.005 when the Euler angles were approximately 12°, 152°, and 37°, and the turnover temperature of frequency was about 30°C at H/λ = 0.005 when the Euler angles were approximately 12°, 153.5°, and 37°.

In addition, it was understood that the turnover temperature of frequency was about 20°C at H/λ = 0.15 when the Euler angles were approximately 12°, 153.5°, and 37°, and the turnover temperature of frequency was about 30°C at H/λ = 0.15 when the Euler angles were approximately 12°, 155°, and 37°.

A region surrounded by Euler angles and H/λ, in which turnover temperature of frequency was set between about 20°C and about 30°C, is represented by the graph in Fig. 8. That is, the turnover temperature of frequency between about 20°C and about 30°C was in the region surrounded by the points of A [Euler angles (12°, 152°, and 37°), H/λ = 0.005], B [Euler angles (12°, 153.5°, and 37°), H/λ = 0.005], C [Euler angles (12°, 153.5°, and 37°), H/λ = 0.15], and D [Euler angles (12°, 155°, and 37°), H/λ = 0.15] or on the lines surrounding the region, and the frequency shift was less in this region or on the line surrounding the region.

In Euler angles (φ, θ, and ϕ) representing a propagating direction of a surface acoustic wave, an error of ± 2° versus 37° in the propagating direction occurred due to an error generated in a process for manufacturing the IDT.

In the first to the third preferred embodiments of the present invention, φ of Euler angles was described in the case in which φ was about 12°; however, in the range of about 12° ± 1°, it was discovered that approximately equivalent values could be obtained. That is, when φ is about 11° or about 13°, effects similar to that at φ = 12° can be obtained.

In addition, in the first to the third preferred embodiments of the present invention, surface acoustic wave resonators, longitudinally coupled surface acoustic wave filters, and transversally coupled surface acoustic wave filters were described by way of examples; however, these are not limiting of the present invention. For example, transversal surface acoustic wave filters having many pairs of transducers and ladder-type filters provided with surface acoustic wave resonators arranged to define a ladder circuit may be used, and equivalent effects can be obtained by surface acoustic wave devices in any form.

Furthermore, in the first to the third preferred embodiments of the present invention, surface acoustic wave resonators provided with a reflector were described; however, this is not limiting of the present invention. The present invention can be applied to surface acoustic wave devices having no reflectors.

While preferred embodiments of the invention have been disclosed, various modes of carrying out the principles disclosed herein are contemplated as being within the scope of the following claims. Therefore, it is understood that the scope of the invention is not to be limited except as otherwise set forth in the claims.

## Claims

**1.** A surface acoustic wave device comprising:
a piezoelectric substrate (2/12/22) including a langasite single crystal; and
an interdigital transducer (3/13/23) provided on the piezoelectric substrate; wherein
Euler angles (φ, θ, and ϕ) defining the orientation of the piezoelectric substrate are about 11° to about 13°, about 152° to about 155°, and about 37° ± 2°, respectively; and
the film thickness H of the interdigital transducer with respect to a wavelength λ of a surface acoustic wave excited on the piezoelectric substrate is between about 0.005 to about 0.15.

**2.** A surface acoustic wave device according to Claim 1, wherein the interdigital transducer is made of Al.

**3.** A surface acoustic wave device according to Claim 1, wherein the interdigital transducer is made of Au.

**4.** A surface acoustic wave device according to any previous Claim, wherein the piezoelectric substrate is made of a La₃Ga₅SiO₁₄ single crystal.

**5.** A surface acoustic wave device according to any previous Claim, wherein reflectors (4/14/24) are provided on opposite ends of the piezoelectric substrate.

**6.** A surface acoustic wave device according to any previous Claim, wherein the device is a resonator.

**7.** A surface acoustic wave filter comprising:
a surface acoustic wave resonator according to claim 6 8. A duplexer (34) comprising:
a surface acoustic wave device according to any one of Claimns 1 to 6.

**9.** A communication apparatus (31) comprising:
a surface acoustic wave device according to any one of Claims 1 to 6.

**10.** A surface acoustic wave device comprising:
a piezoelectric substrate (2/12/22) made a langasite single crystal; and
an interdigital transducer (3/13/23) disposed on the piezoelectric substrate,
wherein, when Euler angles (12°, θ, and 37°) of the piezoelectric substrate are plotted on the abscissa and a ratio H/λ of the film thickness H of the interdigital transducer with respect to a wavelength λ excited on the piezoelectric substrate is plotted on the ordinate, θ and H/λ of the surface acoustic wave device are included in an region surrounded by the points listed below or on the lines surrounding the region,
A (θ = 152°, H/λ = 0.005),
B (θ = 153.5°, H/λ = 0.005),
C (θ = 155°, H/λ = 0.15),
D (θ = 153.5°, H/λ = 0.15).
